Europäisches Patentamt

European Patent Office

Office européen des brevets

(11) Numéro de publication: **0 197 847 B1**

# FASCICULE DE BREVET EUROPÉEN

(45) Date de publication du fascicule du brevet:
06.12.89

(51) Int. Cl.⁴: **G 06 K 19/06**, H 01 L 23/48

(21) Numéro de dépôt: **86400670.5**

(22) Date de dépôt: **27.03.86**

(54) Procédé de fabrication de cartes à mémoire électronique et cartes obtenues suivant ledit procédé.

(30) Priorité: **28.03.85 FR 8504658**

(43) Date de publication de la demande:
**15.10.86 Bulletin 86/42**

(45) Mention de la délivrance du brevet:
**06.12.89 Bulletin 89/49**

(84) Etats contractants désignés:
**AT BE CH DE GB IT LI NL SE**

(56) Documents cité:
**FR-A-2 538 930**
**GB-A-2 081 644**
**GB-A-2 096 541**

(73) Titulaire: **SCHLUMBERGER INDUSTRIES, 50, avenue Jean Jaurès, F-92120 Montrouge (FR)**

(72) Inventeur: **Mollet, Jean- Paul, 47, Elysée 2, F-78170 La Celle St Cloud (FR)**
Inventeur: **Rebjock, Alain, 28, chemin des Bourgognes, F-95000 Cergy (FR)**
Inventeur: **Hayart, Jean- Louis, 34 rue Gambetta, F-92000 Malakoff (FR)**

(74) Mandataire: **Dronne, Guy, SCHLUMBERGER INDUSTRIES Centre de Recherches/SMR BP 620-05, F-92542 Montrouge Cédex (FR)**

## Description

La présente invention a pour objet un procédé de réalisation de cartes à mémoire électronique du type contenant un circuit intégré et des cartes obtenues par la mise en oeuvre dudit procédé.

Les cartes à mémoire électronique permettant à leurs titulaires d'effectuer un certain nombre de transactions sont maintenant bien connues. Elles peuvent appartenir à deux grandes catégories. Certaines cartes ont un circuit électronique suffisamment élaboré pour permettre de recharger des valeurs fiduciaires dans la mémoire de la carte. En d'autres termes, lorsque la valeur fiduciaire initiale de la carte est épuisée l'utilisateur, moyennant un nouveau paiement, peut faire recharger sa carte à une nouvelle valeur fiduciaire. Un deuxième type de carte dite pré-payée contient un circuit électronique plus simple et la carte est chargée une fois pour toute à une valeur fiduciaire donnée. Lorsque cette valeur a été épuisée par l'utilisateur la carte est à jeter.

Dans le cas des cartes prépayées qui, donc, ne serviront qu'une fois, on comprend qu'il est nécessaire que le coût de fabrication de la carte soit aussi réduit que possible afin que ce coût ne soit pas prohibitif par rapport à la valeur fiduciaire nécessairement réduite stockée. Cela est obtenu en partie du fait que le circuit électronique lui-même est sensiblement moins onéreux que celui qu'on trouve dans une rechargeable. Cependant, la fabrication de la carte elle-même intervient de façon aussi non négligeable dans le prix final de la carte. On sait que la carte se compose essentiellement d'un corps en matière plastique dans lequel est logé un module électronique comportant le circuit intégré, les plages de contact pour assurer la connexion avec le lecteur de carte et des connexions électriques entre le circuit intégré et les plages de contact. La fixation du module électronique dans le corps de la carte doit être suffisamment efficace pour que l'ensemble ainsi obtenu satisfasse aux tests de flexion auxquels la carte est soumise. En outre, l'épaisseur de la carte est standardisée et cette épaisseur est de l'ordre du millimètre. On comprend que cette épaisseur réduite rend plus délicates encore l'implantation et la fixation du module électronique dans la carte.

Plusieurs procédés d'implantation du module électronique dans le corps de la carte ont déjà été proposés. Selon un premier procédé, le module électronique est placé entre deux couches du matériau plastique servant à constituer le corps de la carte et cet ensemble est thermocomprimé pour obtenir la forme finale de la carte, le circuit intégré étant noyé dans le corps de la carte.

Selon un autre procédé, on part d'un corps de carte déjà réalisé et on usine dans le corps de la carte une cavité pour venir y placer et y coller le module électronique. Une telle technique est très délicate de mise en oeuvre, car l'usinage doit être réalisé avec une grande précision afin que, après mise en place du module dans la cavité, les bornes de contact du module électronique affleurent à la surface du corps de la carte.

Pour remédier à ces inconvénients, on a proposé dans la demande de brevet européen 128 822 un procédé d'implantation du module électronique dans le corps de la carte qui consiste à ménager dans le corps de la carte une cavité dont les dimensions sont inférieures à l'encombrement du module électronique et à chauffer localement le corps de la carte, tout en appliquant avec pression le module électronique sur le corps de la carte de telle manière qu'au moins une partie du module électronique serve de poinçon pour compléter la définition de la cavité de la carte. La fusion partielle du matériau plastique constituant la carte permet d'obtenir un très bon accrochage du module électronique dans le corps de la carte et évite par ailleurs un usinage précis de celle-ci.

Pour améliorer encore l'implantation du module électronique dans la carte, un objet de l'invention est de fournir un procédé d'implantation du module électronique dans le corps de la carte qui ne nécessite aucun usinage du corps de la carte à des cotes précises, tout en permettant un contrôle aisé des déformations de la carte lors de l'implantation du module électronique dans celle-ci.

Pour atteindre ce but, selon l'invention, le procédé de réalisation d'une carte à mémoire électronique comprenant un corps réalisé en un matériau thermoplastique présentant deux faces principales sensiblement parallèles entre elles et un module électronique comportant: un support de forme générale aplatie présentant deux faces principales, des plages de contact disposées sur la première face principale dudit support une pastille semi-conductrice dans laquelle est formée un circuit intégré, disposée sur la deuxième face principale dudit support, et des connexions électriques pour relier les bornes de ladite pastille auxdites plages, comprend l'étape de réaliser dans le corps de ladite carte une cavité comprenant un premier évidement débouchant dans une première face principale dudit corps et présentant un fond sensiblement parallèle auxdites faces principales dudit corps, et un deuxième évidement débouchant dans ledit fond les premier et deuxième évidements ayant, dans des plans parallèles auxdites faces principales du corps, des dimensions respectivement supérieures à celles dudit support isolant et de ladite pastille, et il se caractérise en ce qu'il comprend de plus les étapes suivantes:

a) on réalise dans ledit fond une pluralité d'aspérités faisant saillie dans ledit premier évidement et séparées par les interstices communiquant entre eux par les interstices communiquant entre eux et avec ledit deuxième évidement, les distances entre ladite première face principale du corps et respectivement ledit fond et l'extrémité desdites aspérités étant respectivement supérieure et inférieure à l'épaisseur dudit support isolant:

b) On place ledit module dans ladite cavité de telle manière que ladite pastille pénètre partiellement dans ledit deuxième évidement et que ledit support pénètre partiellement dans ledit premier évidement, la partie dudit support isolant non recouverte par ladite pastille reposant sur lesdites aspérités:

c) On porte localement lesdites aspérités à leur température de ramollissement, et on applique avec pression ledit module électronique en écrasant l'extrémité desdites aspérités jusqu'à ce que lesdites plages de contact soient sensiblement dans le plan de ladite première face principale dudit corps, ledit support adhérant ainsi audites aspérités; et

d) On fait pénétrer une colle isolante au moins dans lesdits interstices entre ledit fond et ledit support pour terminer le collage dudit module électronique dans ledit corps de la carte.

On voit qu'un tel procédé répond effectivement aux deux conditions énoncées précédemment. D'une part il n'y a aucune nécessité d'avoir un usinage à une cote très précise de la cavité de départ ménagée dans le corps de la carte puisque le positionnement précis du module électronique par rapport au corps de la carte se fait en écrasant plus ou moins l'extrémité des aspérités prévues dans la cavité. On voit également que le fluage résultant de l'écrasement des aspérités est entièrement localisé dans les espaces séparant ces aspérités. De plus, l'écrasement étant limité, les volumes de matière soumises à fluage sont réduits. On peut remarquer de plus que l'ensemble des aspérités définit, pour l'introduction de la colle, des canaux favorisant l'étalement de la colle par capillarité tout en limitant la progression de celle-ci à l'espace compris entre le support isolant du module électronique et la face de la cavité comportant les aspérités.

Selon un premier mode de réalisation le deuxième évidement débouche également dans la deuxième face principale du corps de la carte, et l'étape d) est mise en oeuvre après l'étape c).

Selon un deuxième mode de réalisation le deuxième évidement est borgne, et entre l'étape b) et l'étape c) on place dans le deuxième évidement une goutte de colle.

L'invention concerne également des cartes à mémoire électronique ayant une structure du type de celle qu'on obtient par le procédé défini précédemment dans ses différents modes de mise en oeuvre.

La description de plusieurs modes de réalisation de l'invention donnés à titre d'exemples non limitatifs. Se réfère au dessin annexé sur lequel:

– la figure 1 est une vue en coupe verticale d'un module électronique susceptible d'être implanté dans le corps de la carte;

– les figures 2 à 5 illustrent les différentes opérations effectuées sur le corps de la carte pour préparer l'implantation du module selon un premier mode de mise en oeuvre de l'invention;

– les figures 6 et 7 illustrent les étapes du premier mode de mise en oeuvre du procédé consistant à venir placer le module électronique dans la cavité réalisée par les étapes illustrées sur les figures 2 à 5;

– la figure 8 montre la structure finale de la carte selon le premier mode de mise en oeuvre de l'invention, le module électronique étant fixé dans la cavité; et

– les figures 9 à 12 illustrent un deuxième mode de mise en oeuvre du procédé selon l'invention. Elles montrent les étapes successives de ce mode de mise en oeuvre, les figures 10 à 12 étant des vues en coupe verticale, la figure 9 étant une demi-vue de dessus.

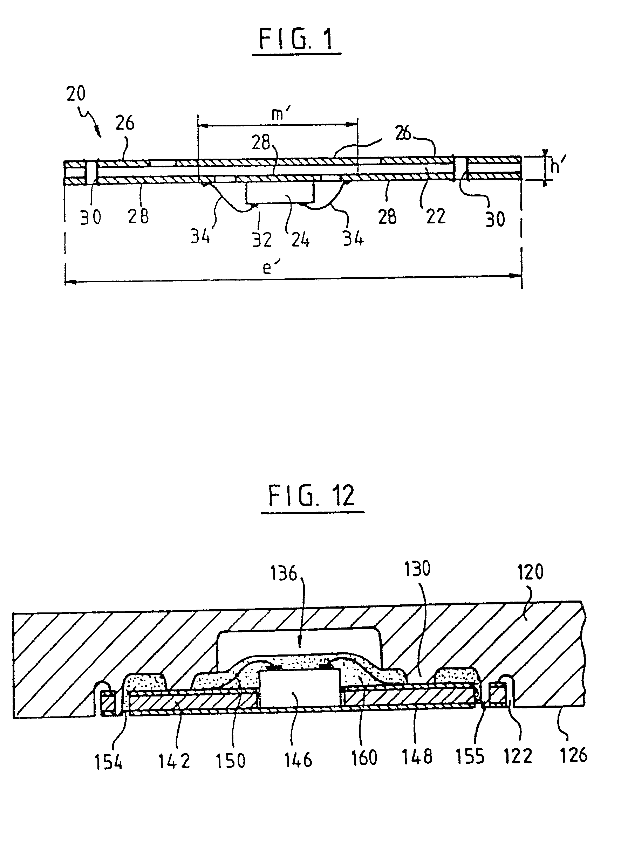

En se référant tout d'abord à la figure 1 on va décrire un module électronique utilisable dans l'invention. Le module électronique 20 comprend essentiellement un support isolant 22 réalisé par exemple dans le matériau commercialisé sous la marque MYLAR, ou tout autre support isolant une pastille semi-conductrice dans laquelle est réalisé un circuit intégré 24 et des plages de contact 26 réalisées sur une des faces du support isolant 22. le circuit intégré 24 reposant sur l'autre face. Pour réaliser les différentes connexions entre le circuit intégré 24 et les plages de contact 26, la deuxième face du support isolant 22 est pourvue de métallisations formant connexion électrique référencées 28. En outre, des trous métallisés tels que 30 assurent la liaison électrique entre les pistes conductrices 28 et les plages de contact 26. Enfin, la liaison entre les pistes conductrices 28 et les bornes telles que 32 du circuit intégré 24 sont assurées par des fils conducteurs tels que 34.

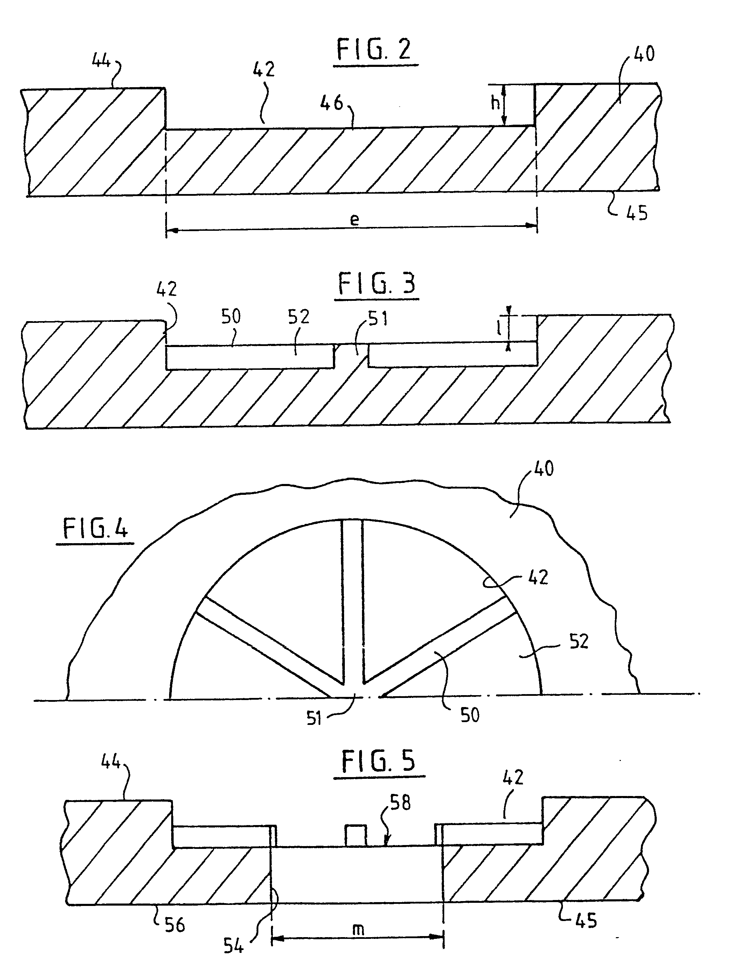

Selon un premier mode de mise en oeuvre de l'invention, c'est ce module électronique 20 qui est implanté dans le corps de la carte selon les étapes que l'on va décrire maintenant en liaison avec les figures 2 à 8. Ce module électronique est décrit plus en détail dans la demande de brevet européen déjà mentionnée.

Comme le montre la figure 2. on part d'un corps de carte 40 réalisé en un matériau plastique tel que du PVC qui comporte à l'emplacement où on veut implanter le module électronique un évidement supérieur 42. Le corps de la carte a une forme paralélépipédique rectangle limitée par deux faces principales parallèles entre elles respectivement supérieure 44 et inférieure 45. Le fond 46 de l'évidement 42 est sensiblement parallèle à la face supérieure 44 du corps 40. Cet évidement débouche dans la face supérieure 44 de la carte, c'est-à-dire celle dans laquelle doivent se trouver les plages de connexion électrique avec le lecteur de cartes. L'évidement 42, qui est par exemple circulaire, a une dimension $e$ dans le plan de la face 44 qui est légèrement supérieure à la dimension correspondante $e'$ du support isolant du module électronique. La profondeur $h$ de cet évidement 42 entre la face 44 du corps de la carte et le fond 46 de l'évidement 42 est un peu supérieure à la dimension $h'$ de l'épaisseur de l'ensemble constitué par le substrat isolant du module électronique et les métallisations réalisées sur celui-ci. Dans l'étape suivante, représentée sur la figure 3 on déforme par déformation plastique localisée le fond 46 de l'évidement 42 pour créer un ensemble d'aspérités telles que 50. Ces aspérités sont formées de telle manière que la distance moyenne entre la face 44 supérieure du corps de la carte et l'extrémité supérieure des aspérités 50 qui est notée *l* sur la figure 3 soit inférieure à l'épaisseur h' du support du module électronique. Comme le montre mieux la figure 4 les aspérités 50 laissent entre elles des interstices 52 communiquant tous entre eux. La hauteur des aspérités 50 est de l'ordre de 0,2 à 0,3 mm.

Selon le mode de réalisation décrit ici, ces aspérités ont la forme de nervures rayonnantes 50 s'étendant de la paroi de l'évidemment 42 jusqu'à une partie centrale commune 51. Les aspérités pourraient avoir d'autres formes. Par exemple elles pourraient être constituées par des pointes régulièrement réparties sur le fond 46 de l'évidement 42.

Dans l'étape suivante, représentée sur la figure 5 on perce un évidement inférieur 54 qui fait communiquer l'évidement supérieur 42 avec la face inférieure 45 du corps de la carte. Cet évidement est également, par exemple, de section circulaire, et son diamètre m est légèrement supérieur à la plus grande dimension m' du circuit intégré muni de ses fils de connexion 34. Comme on le voit sur la figure 5, la dimension m est nettement inférieure à la dimension e. Ainsi, l'ensemble des évidements 42 et 54 forme une cavité 58 qui traverse de part en part le corps 40 de la carte et qui comporte une partie 42 de plus grande dimension et une partie 54 de dimension réduite ces deux parties étant raccordées par la portion restante du fond 46 de l'évidement supérieur 42 muni de ses aspérités 50.

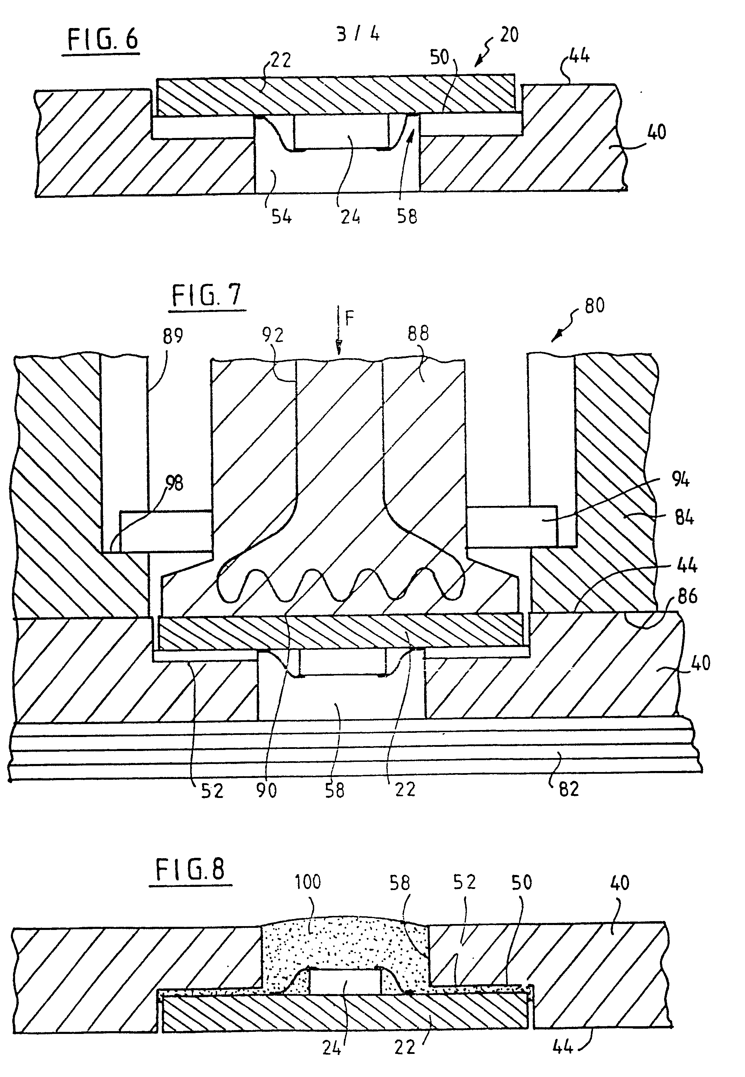

En se référant maintenant aux figures 6 à 8 on va décrire l'implantation du module électronique 20 selon le premier mode de mise en oeuvre. Pour simplifier ces figures on a fait apparaître pour le module électronique 20 uniquement le support isolant 22 qui comprend en fait de plus les métallisations et le module électronique 24. De plus, pour rendre plus claires ces figures on n'a pas respecté l'échelle, et les épaisseurs sont très sensiblement augmentées par rapport aux dimensions dans le plan de la carte Comme le montre la figure 6 on place le module électronique dans la cavité 58. Plus précisément, le substrat isolant 22 repose sur l'extrémité des aspérités 50 et le module électronique 24 pénètre partiellement dans la partie inférieure 54 de la cavité 58. En outre, la face du module électronique portant les plages de contact fait saillie hors de la face supérieure 44 du corps de la carte.

Dans l'étape suivante, illustrée par la figure 7, on porte les extrémités des aspérités 50 à la température de ramollissement du matériau dont elles sont constituées soit environ 175°C. et simultanément on applique avec pression l'ensemble du module sur ces aspérités portées à température

re de ramollissement jusqu'à ce que la face supérieure du substrat isolant c'est-à-dire en fait les plages de contact soient sensiblement de niveau avec la face supérieure 44 du corps de la carte. On comprend que, lors de cette opération, seul le matériau localisé dans les aspérités va être soumis à un fluage, le matériau migrant pour remplir très partiellement les interstices 52 entre les aspérités. Il en résulte que la modification de la géométrie du corps de la carte est limitée à la zone comportant les aspérités, c'est-à-dire à une zone qui est interne à la carte. La hauteur des aspérités 50, après leur déformation est de l'ordre de 0,03 à 0,05 mm.

Sur la figure 7 on a également représenté l'ensemble de l'outil 80 pour réaliser ces deux opérations. Le corps de la carte est placé sur un socle 82. L'outil 80 comporte une partie fixe 84 dont la face inférieure 86 repose sur la face supérieure 44 du corps de la carte tout autour de la cavité 58. L'outil comporte une partie mobile 88 qui peut coulisser par rapport à la partie fixe 84 dans un alésage 89 selon la direction F c'est-à-dire selon une direction perpendiculaire aux faces principales de la carte. L'outil comporte essentiellement une face inférieure 90 en contact avec le support isolant 22 du module électronique et un élément de chauffage figuré en 92 par une résistance chauffante. En outre, la partie mobile 88 comporte des ergots 94 qui peuvent venir en butée sur une portée de fin de course 98 ménagée dans la partie fixe 84 de l'outil 80. Grâce a la résistance chauffante 92, portée à une température de l'ordre de 175°C, le substrat isolant 22 est chauffé et cet échauffement est transmis au matériau formant les aspérités 50. En outre, la partie mobile 88 permet d'appliquer une certaine pression sur le module électronique 20. La course de la partie mobile est limitée par la coopération des ergots 94 et de la portée de fin de course 98. Ces deux éléments sont déterminés pour qu'en position de fin de course la face supérieure du substrat isolant 22 soit sensiblement au même niveau que la face supérieure 44 du corps de la carte. A la fin de cette étape l'ensemble du module électronique est parfaitement positionné par rapport au corps de la carte. De plus la fusion partielle de l'extrémité des aspérités 50 au contact du substrat isolant 22 produit un certain accrochage de celui-ci, assurant ainsi entre le corps 20 et le module électronique une liaison au moins temporaire. En outre, malgré le fluage des aspérités 50, les interstices 52 sont demeurés et communiquent tous avec la cavité 58.

La figure 8 illustre la dernière étape du procédé. L'ensemble de la carte avec son module électronique 20 est retourné. Cette opération est rendue possible du fait que le module électronique est déjà accroché au corps de la carte par la fusion partielle des aspérités. Par la cavité 58, on introduit par simple gravité une goutte 100 de colle époxy isolante. Par capillarité, la colle suit les interstices 52 entre les aspérités 50. Toutefois, par l'effet de capilarité la progression de la colle est limitée à la zone disposée entre le support isolant 22 et le fond de la cavité supérieure 42. Ainsi, il n'y a pas de problème de remontée de colle sur la face 44 de la carte ou sur la face du module électronique portant les plages de contact.

Il découle de la description précédente que le procédé selon l'invention présente de nombreux avantages par rapport aux techniques antérieures. Il ne nécessite aucun usinage du corps de la carte à des cotes précises pour réaliser la cavité où est logé le module électronique. Il n'y a pas d'opération de pré-encollage du module où de la cavité. Il n'est donc pas nécessaire de contrôler avec précision la quantité de colle utilisée. Le ramollissement du matériau plastique formant le corps de la carte est très localisé et n'intéresse qu'un faible volume de matière. Le fluage qui en résulte est donc également très limité, et, de plus, il ne concerne pas les faces externes de la carte donc les cotes doivent satisfaire à des normes précises.

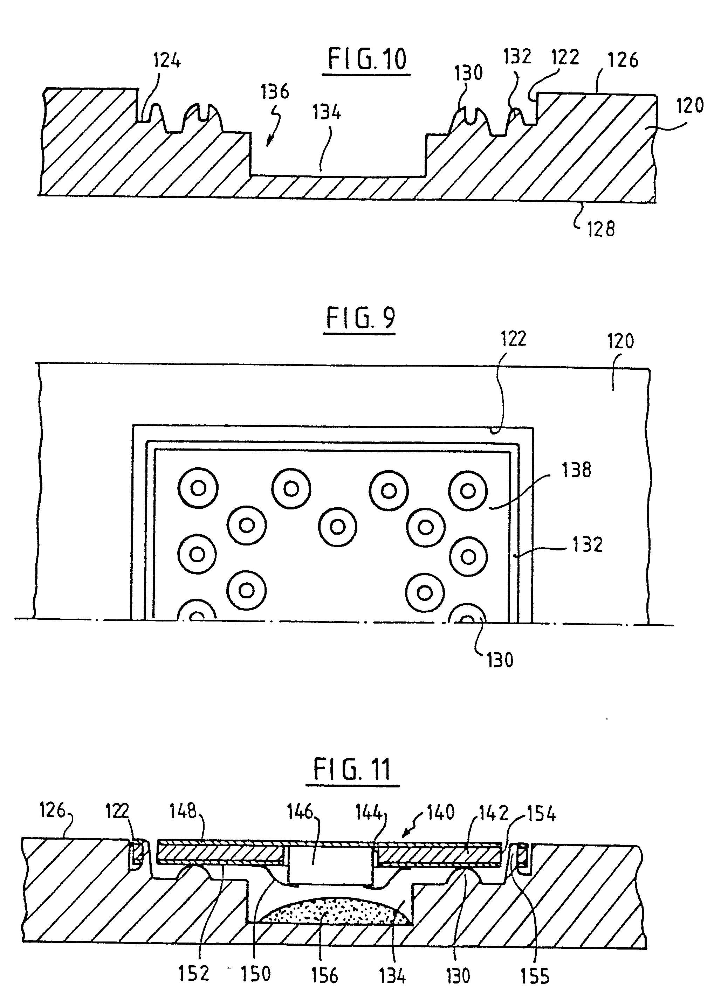

En se référant aux figures 9 à 12, on va décrire un deuxième mode de mise en oeuvre du procédé selon l'invention. Selon ce mode de réalisation, et contrairement à ce qu'on obtient avec le premier mode de réalisation, la cavité dans laquelle est logé le module électronique est borgne et ne débouche pas dans la face inférieure du corps de la carte ce qui peut être utile pour certaines applications.

On part d'un corps de carte 120 identique à celui de la figure 2. Il comporte un évidement supérieur 122 qui a, dans l'exemple décrit, une forme rectangulaire, et qui présente un fond 124 et une profondeur de l'ordre de 200 µm. Le corps de la carte présente une face principale supérieure 126 dans laquelle est percé l'évidement 122 et une face principale inférieure 128.

A partir de cette structure on réalise dans le fond 124 de l'évidement 122 des aspérités faisant saillie dans l'évidement 122 et ayant la forme représentée sur la figure 9. Les aspérités comprennent des picots tels que 130 disposés sensiblement sur un rectangle et une nervure continue 132 c'est-à-dire disposée selon une courbe fermée, ayant, dans l'exemple considéré, une forme rectangulaire en vue de dessus. La nervure 132 entoure totalement l'ensemble des picots 130. Ces aspérités 130 et 132 sont obtenues par déformation plastique. Elles ont une hauteur de 0,2 à 0,3mm.

Dans l'étape suivante on réalise dans la partie centrale du fond 124 un évidement inférieur 134 qui est borgne, c'est-à-dire qui ne débouche pas dans la face inférieure 128 du corps 120 de la carte. L'ensemble des évidements 122 et 134 forme une cavité 136 pour loger le module électronique. Les figures 9 et 10 montrent que, à l'intérieur de la zone limitée par la nervure 132, les picots 130 laissent entre eux des interstices 138 qui communiquent tous avec l'évidement inférieur 134.

Dans ce deuxième mode de mise en oeuvre on utilise un module électronique 140 représenté sur la figure 11. Le module électronique 140 diffère du module électronique 20 de la figure 1 par le fait que le support isolant 142 comporte une fenêtre 144 dans laquelle est partiellement logée la pastille semi-conductrice 146. Le dos de la pastille 146 est directement collé avec une colle conductrice, sur une des métallisations 148 déposées sur la face supérieure du support isolant 142 et qui forment les plages de connexion avec le lecteur de carte. La liaison électrique entre les bornes de la pastille 146 et les autres plages de contact 148 sont réalisées par des fils conducteurs 150, des métallisations 152 déposées sur l'autre face du support isolant et des trous métallisés 154 traversant toute l'épaisseur du support isolant 142. Pour avoir une description plus détaillée du module électronique 140 on se reportera à la demande de brevet européen déjà citée. Cette structure particulière de module électronique a pour intérêt d'avoir une épaisseur totale réduite.

Les cotes du module électronique 140 vérifient les mêmes relations avec les cotes de la cavité 136 que celles qui ont été décrites en liaison avec le premier mode de mise en oeuvre. Dans l'étape suivante on dépose une goutte 156 de colle époxy dans l'évidement inférieur 134. Puis on procède exactement comme lors des étapes du premier mode de mise en oeuvre du procédé décrites en liaison avec les figures 6 et 7. On place le module électronique 140 dans la cavité 136 de telle manière que le support isolant 142 repose par ses métallisations 152 sur l'extrémité des aspérités 130, 132.

Puis, à l'aide d'un outil identique à celui qui est représenté sur la figure 7, on chauffe le module électronique 140 en lui appliquant une certaine pression, ce qui entraîne le ramollissement du matériau constituant les aspérités et leur écrasement selon le processus décrit en détail en liaison avec la figure 7. Il faut ajouter que, comme le montre la figure 11 la nervure 132 est positionnée pour être partiellement en regard des trous métallisés 154 du module électronique 140. L'écrasement de la nervure 132 s'accompagné de remontées 155 du matériau plastique dans une partie des trous métallisés 154. L'accrochage du module sur le corps de la carte est ainsi amélioré.

Dans la dernière étape, on procède du collage final du module électronique sur le corps de la carte. Pour cela, la carte est retournée, comme cela est montré sur la figure 12. On chauffe légèrement le face inférieure 128 du corps de la carte au droit de la cavité 136 aux environs de 40°C. Ce chauffage, joint au retournement de la carte, permet la dispersion de la goutte de colle époxy 156 qui se dépose sur la pastille 146 et les fils 150 assurant ainsi leur consolidation mécanique. En outre, par capillarité, la colle vient remplir les interstices 138 entre le support isolant 142 et le fond 124 de l'évidement 122. La progression de la colle est limitée par la présence de la nervure 132. Au niveau des trous métallisés, la progression de la colle est limitée par tension superficielle du fait que ces trous, dont les dimensions sont réduites, sont en plus partiellement remplis par le matériau plastique (remontées 155).

Une autre façon de réaliser le collage dans le cas ou la cavité est borgne, consiste à prévoir deux trous traversant le support isolant 142 du module électronique dans sa partie disposée à l'intérieur de la nervure 132. Par un de ces trous on injecte la colle et par l'autre trou on contrôle le niveau de colle dans la cavité. Lorsque la colle affleure la face externe du substrat isolant dans le deuxième trou on interrompt l'injection de colle. En se solidifiant la colle remplit la cavité et obture les deux trous.

On comprend que le deuxième mode de mise en oeuvre du procédé selon l'invention présente les mêmes avantages que le premier mode de mise en oeuvre, ce mode de mise en oeuvre présente l'avantage supplémentaire de laisser intact le dos de la carte. De plus, la présence parmi les aspérités de la nervure continue 132 assure qu'il n'y aura pas de remontée de colle vers la face supérieure 126 de la carte puisque la nervure constitue une barrière continue s'opposant à la progression de la colle.

Il faut comprendre de plus que la forme particulière des aspérités 130 et 132 représentées sur les figures 9 et 10 pourraient être utilisées dans le cadre du premier mode de mise en oeuvre en remplacement des aspérités 50 en forme de nervures rayonnantes.

Il faut souligner que ce procédé présente de nombreux avantages par rapport aux précédés antérieurs. D'une part la fixation du module électronique dans la carte est améliorée puisqu'elle est obtenue à la fois par la présente de la colle et par l'adhérence du matériau plastique au module. D'autre part, la cote finale des plages de contact par rapport à la face supérieure du corps de la carte peut être contrôlée avec précision quelles que soient les caractéristiques du matériau plastique formant la carte.

**Revendication**

1. Procédé de réalisation d'une carte à mémoire électronique comprenant un corps (40, 120) réalisé en un matériau thermoplastique présentant deux faces principales (44, 45, 126, 128) sensiblement parallèles entre elles et un module électronique (20, 140) comportant: un support (22, 142) de forme générale aplatie présentant deux faces principales, des plages de contact (26, 148) disposées sur la première face principale dudit support (22, 142), une pastille semi-conductrice (24, 146) dans laquelle est formée un circuit intégré, disposée sur la deuxième face principale dudit support, et des connexions électriques pour relier les bornes de ladite pastille auxdites plages, procédé dans lequel on réalise dans le corps (40, 120) de ladite carte une cavité (58, 136) comprenant un premier évidement (42, 122) débouchant dans une première face principale (44, 126) dudit corps et présentant un fond (46, 124) sensiblement parallèle auxdites faces principales (44, 45, 126, 128) dudit corps, et un deuxième évidement (54, 134) débouchant dans ledit fond (46, 124) les premier et deuxième évidements (42, 54, 122, 134) ayant, dans des plans parallèles auxdites faces principales du corps, des dimensions respectivement supérieures à celles dudit support isolant (22, 142) et de ladite pastille (24, 146), ledit procédé étant caractérisé en ce qu'il comprend de plus les étapes suivantes:

a) on réalise dans ledit fond une pluralité d'aspérités (50, 130, 132) faisant saillie dans ledit premier évidement (42, 122) et séparées par les interstices (52, 138) communiquant entre eux et avec ledit deuxième évidement (54, 134), les distances entre ladite première face principale (44, 126) du corps et respectivement ledit fond et l'extrémité desdites aspérités étant respectivement supérieure et inférieure à l'épaisseur dudit support (22, 142);

b) On place ledit module (20, 146) dans ladite cavité (58, 136) de telle manière que ladite pastille pénètre partiellement dans ledit deuxième évidement (54, 134) et que ledit support (22, 142) pénètre partiellement dans ledit premier évidement (42, 122), la partie dudit support non recouverte par ladite pastille (20, 146) reposant sur lesdites aspérités (50, 130, 132);

c) On porte localement lesdites aspérités (50, 130, 132) à leur température de ramollissement, et on applique avec pression ledit module électronique (20, 140) en écrasant l'extrémité desdites aspérités (50, 130, 132) Jusqu'à ce que lesdites plages de contact (26, 148) soient sensiblement dans le plan de ladite première face principale (44, 126) dudit corps, ledit support adhérant ainsi auxdites aspérités, et;

d) On fait pénétrer une colle isolante au moins dans lesdits interstices (52, 138) entre ledit fond (46, 124) et ledit support isolant (22, 142) pour terminer le collage dudit module électronique dans ledit corps (40, 120) de la carte.

2. Procédé selon la revendication 1, caractérisé en ce que, pour mettre en oeuvre l'étape c), on chauffe ledit support (22, 142) pour qu'il porte lesdites aspérités (50, 130, 132) à leur température de ramollissement et simultanément on applique une pression sur ledit support isolant.

3. Procédé selon l'une quelconque des revendications 1 et 2, caractérisé en ce que ledit deuxième évidement (54) débouche également dans ladite deuxième face principale (45) dudit corps.

4. Procédé selon la revendication 3. caractérisé en ce que, pour mettre en oeuvre l'étape d) on introduit par ledit deuxième évidement (54) de la colle isolante qui pénètre par capillarité dans lesdits interstices (52) entre ledit support (22) et ledit fond (46).

5. Procédé selon l'une quelconque des revendications 3 et 4, caractérisé en ce que, pour mettre en oeuvre l'étape a), on réalise d'abord ledit premier évidement (42), on forme dans son fond (46) lesdites aspérités (50) et on réalise ledit deuxième évidement (54).

6. Procédé selon la revendication 5, caractérisé en ce que lesdites aspérités (50, 130, 132) sont réalisées par déformation plastique localisée dudit fond (46).

7. Procédé selon l'une quelconque des revendications 1 et 2, caractérisé en ce que ledit deuxième évidement (134) est borgne.

8. Procédé selon la revendication 7, caractérisé en ce que, avant l'étape b), on dépose dans ledit deuxième évidement (134) de la colle isolante (156) et en ce que, pour mettre en oeuvre l'étape d) on retourne la carte pour que le deuxième évidement (134) soit au-dessus dudit premier évidement (122) et on chauffe ladite deuxième face (128) du corps (120) au droit dudit deuxième évidement (134).

9. Procédé selon l'une quelconque des revendications 1 à 8, caractérisé en ce que lesdites aspérités comprennent une nervure (132) disposée selon une ligne fermée et une pluralité de picots (130) faisant saillie de la partie dudit fond (124) située entre ladite nervure (132) et ledit deuxième évidement (134).

10. Carte à mémoire électronique comprenant un corps (40, 120) réalisé en un matériau thermoplastique et muni d'une cavité (58, 136) formée d'un premier évidement (42, 122) débouchant dans une première face principale (44, 126) du corps de la carte et un deuxième évidement (54, 134) débouchant dans le fond (46, 124) dudit premier évidement, et un module électronique (20, 140) logé dans ladite cavité comprenant un substrat (22, 142) situé dans ledit premier évidement muni sur sa face externe de plages de contact (26, 148) disposées sensiblement dans le même plan que ladite première face principale du corps de la carte et muni sur sa face interne d'une pastille (24, 146) en matériau semi-conducteur et de connexions électriques, caractérisée en ce qu'elle comprend en outre une pluralités d'aspérités (50, 130, 132) faisant saillie hors dudit fond et adhérant à la face interne dudit support (22, 142), l'espace (52, 138) compris entre ledit fond, ledit support et lesdites aspérités étant sensiblement rempli par une colle isolante.

11. Carte selon la revendication 10, caractérisée en ce que ledit deuxième évidement (134) est borgne et en ce que ladite col le recouvre également au moins partiellement ladite pastille (146) et lesdites connexions.

12. Carte selon la revendication 10, caractérisée en ce que ledit deuxième évidement (54) débouche dans la deuxième face principale (45) du corps de la carte, la partie dudit deuxième évidement non occupée par ladite pastille étant remplie par ladite colle isolante.

13. Carte à mémoire selon l'une quelconque des revendications 10 à 12, caractérisée en ce que lesdites aspérités (50, 130, 132) comprennent une nervure (132) disposée selon une ligne fermée, et une pluralité de picots (130) faisant saillie hors de la partie dudit fond s'étendant entre ledit deuxième évidement (134) et ladite nervure (132).

## Claims

1. A method of providing an electronic memory card comprising a body (40, 120) made of a thermoplastic meterial and having two main faces (44, 45, 126, 128) which are substantially parallel to each other, and an electronic module (20, 140) comprising: a support (22, 142) which is generally flat in shape having two main faces contact tabs (26, 148) disposed on a first one of said main faces of said support (22, 142) a semiconeuctor chip (24, 146) having an integrated circuit formed therein and disposed on the second main face of said support; and electrical connections for connecting the terminals of said chip to said tabs, a method wherein a cavity (58, 136) is made in the body (40, 120) of said card, said cavity including a first hollow (42, 122) opening out into a first main face (44, 126) of said body and having a bottom (46, 124) which is substantially parallel to said main faces (44, 45, 126, 128) of said body, and a second hollow (54, 134) opening into to said bottom (46, 124) said first and second hollows (42, 54, 122, 134) having dimensions in planes parallel to said main faces of said body which are greater respectively than the dimensions of said insulating support (22, 142) and the dimensions of said chip (24, 146) said method being characterised in that it further comprises the following steps:

a) forming in said bottom a plurality of bumps (50, 130, 132) projecting into said first hollow (42, 122) and separated from one another and from said second hollow (42, 122) by intersices (52, 138), communicating with one another and communicating with said second hollow (52, 134) the distances between said first main face (44, 126) of the body and said bottom and the tops of said bumps being respectively greater than and less than the thickness of said support (22, 142);

b) said module (20, 146) is placed in said cavity (58, 136) in such a manner as to cause said chip to penetrate partially into said second hollow (54, 134) and to cause said support (22, 142) to penetrate partially into said first hollow (42, 122), the portion of said support which is not covered by said chip (24, 146) resting on said bumps (50, 130, 132);

c) said bumps (50, 130, 132) are locally raised to their softening temperature and pressure is applied to said electronic module (20, 140) to crush the tops of said bumps (50, 130, 132) until said contact tabs (26, 148) are substantially in the same plane as said main face (44, 126) of said body, said support thus adhering to said bumps: and

d) an insulating glue is caused to penetrate at least into said interstices (52, 138) between said bottom (46, 124) and said insulating support (22, 142) in order to complete adherence between said electronic module and said card body (40, 120).

2. A method according to claim 1, characterised in that step c) is performed by heating said support (22, 142) to bring said bumps (50, 130, 132) to their softening temperature and by simultaneously applying pressure to said insulating support.

3. A method according to anyone of claims 1, and 2 characterised in that said second hollow (54) also opens out into said second main face (45) of said body.

4. A method according to claim 3, characterised in that step d) is performed by inserting insulating glue via said second hollow (54), which glue penetrates by capillarity into said interstices (52) between said support (22) and said bottom (46).

5. A method according to anyone of claims 3 and 4, characterised int that step a is performed by initially providing said first hollow (42), then forming said bumps (50) on its bottom (46), and then providing said second hollow (54).

6. A method according to claim 5, characterised in that said bumps (50, 130, 132) are formed by locally plastically deforming said bottom (46).

7. A method according to anyone of claims 1 and 2, characterised in that said second hollow (134) is blind.

8. A method according to claim 7, characterised in that insulating glue (156) is deposited in said second hollow (134) prior to step b) and in that step d) is performed by turning the card over so that said second hollow (134) is above said first hollow (122) and by heating said second face (128) of the body (120) over said second hollow (134).

9. A method according to anyone of claims 1 to 8 characterised in that said bumps comprise a rib (132) disposed in a closed loop and a plurality of pegs (130) projecting from that portion of said bottom (124) which is situated between said rib (132) and said second hollow (134).

10. An electronic memory card comprising a body (40, 120) made of thermoplastic material and having a cavity (58, 136) constituted by a first hollow (42, 122) opening out into a first main face (44, 126) of the card body and a second hollow (54, 134) opening out into the bottom (46, 124) of said first hollow and an electronic module (20, 140) lodged in said cavity, said module comprising an insulating support (22, 142) situated in said first hollow and having contact tabs (26, 146) on its outside face disposed substantially in the same plane as said first main face of said card body, and provided with a semiconductor chip (24, 148) on its inside face, together with electrical connections, characterised in that it further comprises a plurality of bumps (50, 130, 132) projecting from said bottom and adhering to said inside face of said support (22, 142), the space (52, 138) lying between said bottom, said support, and said bumps, being substantially filled with an insulating glue.

11. A card according to claim 10, characterised in that said second hollow (134) is blind and in that said glue also covers, at least partially, said chip (146) and said connections.

12. A card according to claim 10, characterised in that said second hollow (54) opens out into the second main face (45) of the card body, with the portion of said second hollow which is not occupied by said chip being filled with said insulating glue.

13. A memory card according to anyone of claims 10 to 12, characterised in that said bumps (50, 130, 132) comprise a rib (132) disposed along a closed loop, and a plurality of pegs (130) projecting from the portion of said bottom of said first hollow which is situated between said second hollow (134) and said rib (132).

**Patentansprüche**

1. Verfahren zum Herstellen einer elektronischen Speicherkarte, umfassend einen aus thermoplastischem Material hergestellten Körper (40, 120) mit zwei zueinander im wesentlichen parallelen Hauptseiten (44, 45, 126, 128) und einen elektronischen Modul (20, 140), der umfaßt: einen Support (22, 142) abgeflachter Grundform mit zwei Hauptseiten, Kontaktstücke (26, 148) auf der ersten Hauptseite des Supports ((22, 142), einen Halbleiterchip (24, 146), in dem ein interierter Schaltkreis ausgebildet ist, angeordnet auf der zweiten Hauptseite des Supports, und elektrische Verbindungen zum Anschließen der Anschlüsse des Chips an die Kontaktstücke, bei welchem Verfahren man in dem Kartenkörper (40, 120) einen Hohlraum (58, 136) herstellt, umfassend eine erste, in eine erste Hauptseite (44, 126) des Körpers mündende Ausnehmung (42, 122) mit einem zu den Hauptseiten (44, 45, 126, 128) des Körpers im wesentlichen parallelen Boden (46, 124), und eine zweite, in den genannten Boden (46, 124) mündende Ausnehmung (54, 134), welche ersten und zweiten Ausnehmungen (42, 54, 122, 134) in Ebenen parallel zu den Hauptseiten des Körpers Abmessungen besitzen, die größer sind als die des isolierenden Supports (22, 142) bzw. des Chips (24, 146), welches Verfahren dadurch gekennzeichnet ist, daß es die folgenden Schritte umfaßt:

a) man erzeugt in dem genannten Boden eine Mehrzahl von Unebenheiten (50, 130, 132), die in die erste Ausnehmung (42, 122) hineinragen und durch miteinander und mit der zweiten Ausnehmung (54, 134) in Verbindung stehende Zwischenräume (52, 138) getrennt sind, wobei der Abstand zwischen der ersten Hauptseite (44, 126) des Körpers und dem Boden größer, zwischen der ersten Hauptseite und dem Ende der Unebenheiten kleiner ist als die Dicke des Supports (22, 142);

b) man plaziert den Modul (20, 146) in dem Hohlraum (58, 136) derart, daß der Chip teilweise in die zweite Ausnehmung (54, 134) ragt und der Support teilweise in die erste Ausnehmung (42, 122) ragt, wobei die nicht vom Chip (24, 146) überdeckte Partie des Supports auf den Unebenheiten (50, 130, 132) aufliegt;

c) man bringt lokal die Unebenheiten (50, 130, 132) auf ihre Erweichungstemperatur und preßt den elektronischen Modul (20, 140) unter Zerstörung des Endes der Unebenheiten (50, 130, 132) an, bis die Kontaktstücke (26, 148) im wesentlichen in der Ebene der ersten Hauptseite (44, 126) des Körpers liegen, wodurch der Support an den Unebenheiten anhaftet, und

d) man läßt einen isolierenden Kleber mindestens in die Zwischenräume (52, 138) zwischen dem Boden (46, 124) und dem Isolierenden Support (22, 142) eindringen, um das Verkleben des elektronischen Moduls in dem Kartenkörper (40, 120) zu vollenden.

2. Verfahren nach Anspruch 1, dadurch gekennzeichnet, daß man bei Schritt c) den Support (22, 142) erwärmt, so daß er die Unebenheiten (50, 130, 132) auf ihre Erweichungstemperatur bringt, und man gleichzeitig einen Druck auf den Isolierenden Support ausübt.

3. Verfahren nach einem der Ansprüche 1 und 2, dadurch gekennzeichnet, daß die zweite Ausnehmung (54) außerdem in die zweite Hauptseite (45) des Körpers mündet.

4. Verfahren nach Anspruch 3, dadurch gekennzeichnet, daß man bei Schritt d) isolierenden Kleber in die zweite Ausnehmung (54) einführt, der durch Kapillarwirkung in die Zwischenräume (52) zwischen dem Support (22) und dem Boden (46) eindringt.

5. Verfahren nach einem der Ansprüche 3 und 4, dadurch gekennzeichnet, daß man bei Schritt a) zunächst die erste Ausnehmung (42) herstellt, man in ihrem Boden (46) die Unebenheiten (50) herstellt und man die zweite Ausnehmung (54) herstellt.

6. Verfahren nach Anspruch 5, dadurch gekennzeichnet, daß die Unebenheiten (50, 130, 132) durch lokale plastische Deformation des Bodens (46) hergestellt werden.

7. Verfahren nach einem der Ansprüche 1 und 2, dadurch gekennzeichnet, daß die zweite Ausnehmung (134) blind endet.

8. Verfahren nach Anspruch 7, dadurch gekennzeichnet, daß man vor Schritt b) in der zweiten Ausnehmung (134) isolierenden Kleber (156) deponiert und daß man für Schritt d) die Karte wendet, so daß die zweite Ausnehmung (134) über der ersten Ausnehmung (122) ist, und man die zweite Seite (128) des Körpers (120) an der Stelle der zweiten Ausnehmung (134) erwärmt.

9. Verfahren nach einem der Ansprüche 1 bis 8, dadurch gekennzeichnet, daß die Unebenheiten eine Rippe (132) umfassen, die längs einer geschlossenen Linie verläuft, sowie eine Mehrzahl von Keilspitzen (130), die von dem Teil des Bodens (124) zwischen der Rippe (132) und der zweiten Ausnehmung (134) vorstehen.

10. Elektronische Speicherkarte, umfassend einen aus thermoplastischem Material gefertigten Körper (40, 120), versehen mit einem Hohlraum (58, 136), gebildet von einer ersten, in eine erste Hauptseite (44, 126) des Kartenkörpers mündenden Ausnehmung (42, 122) und von einer zweiten, in den Boden (46, 124) der ersten Ausnehmung münenden Ausnehmung (54, 134), sowie einen in dem Hohlraum liegenden elektronischen Modul (20, 140), umfassend ein in der ersten Ausnehmung angeordnetes Substrat (22, 142), das auf seiner Außenseite im wesentlichen in derselben Ebene wie die erste Hauptseite des Kartenkörpers liegende Kontaktstücke (26, 148) aufweist und auf seiner Inenseite einen Halbleiterchip (24, 146) und elektrische Verbindungen aufweist, dadurch gekennzeichnet, daß sie ferner eine Mehrzahl von von dem Boden hochstehende und an der Innenseite des Supports (22, 142) anhaftende Unebenheiten (50, 130, 132) aufweist, wobei der Raum (52, 138) zwischen dem Boden, dem Support und den Unebenheiten mit isolierendem Kleber im wesentlichen gefüllt ist.

11. Karte nach Anspruch 10, dadurch gekennzeichnet, daß die zweite Ausnehmung (134) blind endet und daß der Kleber gleichermaßen mindestens zum Teil den Chip (146) und die Verbindungen abdeckt.

12. Karte nach Anspruch 10, dadurch gekennzeichnet, daß die zweite Ausnehmung (54) in die zweite Hauptseite (45) des Kartenkörpers mündet, wobei die vom Chip nicht eingenommene Partie der zweiten Ausnehmung mit dem isolierenden Kleber gefüllt ist.

13. Speicher nach einem der Ansprüche 10 bis 12, dadurch gekennzeichnet, daß die Unebenheiten (50, 130, 132) eine längs einer geschlossenen Linie angeordnete Rippe (132) umfassen sowie eine Mehrzahl von Keilspitzen (130), die von dem Teil des Bodens hochstehen, der sich zwischen der zweiten Ausnehmung (134) und der Rippe (132) erstreckt.

## FIG. 1

## FIG. 12

FIG. 2

44   42   46   40

h

45

e

FIG. 3

42   50   52   51

l

FIG.4

40

42

52

51   50

FIG. 5

44   58   42

56   45

54   m

FIG. 6

FIG. 7

FIG. 8

## FIG. 10

## FIG. 9

## FIG. 11